# EUROPEAN PATENT SPECIFICATION

(11) **EP 4 576 337 B1**
(45) Date of publication and mention of the grant of the patent: **09.12.2026**
(21) Application number: 23877437.6
(22) Date of filing: 19.07.2023
(51) Int. Cl.: H01M 10/63, H01M 10/615, H01M 10/48, H01M 10/44, H02J 7/00

(54) **BATTERY HEATING DEVICE AND OPERATING METHOD THEREFOR**
BATTERIEHEIZVORRICHTUNG UND BETRIEBSVERFAHREN DAFÜR
DISPOSITIF DE CHAUFFAGE DE BATTERIE ET SON PROCÉDÉ DE FONCTIONNEMENT

(30) Priority: 14.10.2022 KR 20220132751
(43) Date of publication of application: 25.06.2025
(73) Proprietor: LG Energy Solution, Ltd., Seoul 07335 (KR)
(72) Inventor: MOON, Chi Ho, Daejeon 34122 (KR)
(74) Representative: Goddar, Heinz J.
(86) International application number: PCT/KR2023/010401
(87) International publication number: WO 2024/080507

(56) References cited:
- WO-A1-2014/167914
- DE-T5- 112015 000 880
- KR-A- 20150 030 501
- KR-A- 20170 058 291
- KR-A- 20200 133 220
- KR-A- 20200 146 002
- US-A1- 2017 136 900
- US-A1- 2022 263 144
- US-B1- 10 355 327

## Description

### [TECHNICAL FIELD]

### CROSS-REFERENCE TO RELATED APPLICATION

This application claims priority to and the benefit of Korean Patent Application No. 10-2022-0132751 filed in the Korean Intellectual Property Office on October 14, 2022.

### TECHNICAL FIELD

Embodiments disclosed herein relate to a battery heating apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Batteries undergo different chemical changes therein according to temperatures during charge. When charge is performed in a low-temperature state or a high-temperature state of a battery, performance of the battery may be degraded or a function of the battery may be permanently damaged. For example, during charge of a battery having a temperature being a specific temperature or less, a swelling phenomenon may occur in which the battery swells and thus a function thereof is damaged. To solve this problem, a system has been used to heat a battery when a temperature of the battery is a specific temperature or less before or during charge of the battery. US 2017/0136900 A1 describes a battery system. The system comprises a main battery, a voltage sensor and a current sensor (not shown), a controller, a charging relay provided between a charger and the main battery, a heater in the vicinity of the main battery, and a temperature raising relay. The voltage sensor and the current sensor detect a voltage value and a current value of the main battery, respectively, and the temperature sensor detects a temperature (battery temperature Tb) of the main battery in the vicinity of the main battery. The controller computes a current SOC of the main battery from the detected voltage value, current value, and battery temperature Tb. The charging relay is turned ON or OFF upon reception of a control signal from the controller. The controller turns the charging relay ON to cause external power to be supplied to the main battery. While the charging process is performed, the controller acquires the SOC (current charge value Cb) of the main battery periodically to compare the current charge value Cb with the charge stop value C2. If the current charge value Cb is not lower than the charge stop value C2, the controller stops the charging process. The heater raises the temperature of the main battery by switching the temperature raising relay between ON and OFF upon reception of a control signal from the controller. When the battery temperature Tb is lower than a temperature raising reference temperature Ts, the controller turns the heater ON and starts raising the temperature of the main battery. When the battery temperature Tb reaches the temperature raising stop temperature Te or higher, the controller stops raising the temperature. DE 11 2015 000880 T5 describes an energy storage system for a vehicle. The system includes a battery, voltage, current and temperature sensors, a battery heater, a charger, and a controller. The controller calculates (estimates) the SOC of the battery based on the voltage value, the current value and the temperature value provided by the sensors and performs a charge/discharge control of the battery on the basis of the calculated SOC and the estimated value of the full charge capacity. In a first charging mode (CC), the battery is charged with a first charging power P1 until a charge amount of the battery becomes equal to a first charge amount SOC_th, and a first temperature increasing power Pt is supplied to the battery heater. In a second charging mode (CCCV), the battery is charged with a second charging power P2 as a fixed value after the charge amount of the battery has reached the first charge amount, and a second temperature increasing power Pt is supplied to the battery heater. The sum of the first charging power P1 and the first temperature increasing power Pt is limited by a maximum energy P of the external energy. As a charging efficiency is increased when the temperature of the battery is increased, compared to the case where the temperature of the battery not increased, a certain fraction of the maximum power P of the external energy corresponding to the temperature increase power Pt is used to increase the battery temperature. For a given battery temperature T1, T2, ... the charging time is minimized by a corresponding ratio α1, α2, ... of the temperature increase power Pt and the maximum power P. In addition, in the first charging mode, the charge power P1 emerges as the difference between the maximum power P and the temperature increase power Pt, which depends on the ratio αi, which in turn depends on the battery temperature Ti. WO 2014/167914 A1 describes a battery charging system for a vehicle. The charging system includes a battery, voltage, current and temperature sensors, a battery heater, and a charger as a power source for supplying power to the battery and the battery heater, and separate battery and heater controllers. The battery controller performs charge control of the battery. It reads detection values of the sensors and calculates the remaining capacity (SOC) based on the voltage of the battery and the integrated current amount during vehicle operation. During charging, the remaining capacity (SOC) is estimated by a known method from the integrated value (integrated current) of the battery voltage and the charging current. The battery controller further calculates a chargeable power based on the voltage of the battery, and sends the calculation result to the charger. It is known that the chargeable power of the battery decreases as the battery voltage increases, that is, as the remaining capacity (SOC) increases. The charger determines a charging power to be supplied to the battery based on the maximum value of power that can be output and the chargeable power of the battery. The heater controller controls operation of the battery heater. In a first charging phase (T1 to T2), constant power charging is performed at the maximum value of the power that can be output from the charger. Therefore, the heater controller does not operate the battery heater in the first charging phase. In a second charging phase (T2 to T3), the charging current gradually decreases, the current charging power becomes smaller than the output possible power of the charger, and the heater output possible power becomes larger than zero. At this time, since the battery temperature is equal to or lower than the heating target temperature, the battery heater is operated using all of the surplus power and heating of the battery is started. When the battery temperature reaches the heating target temperature at timing T3, the battery heater is stopped and the charging is terminated at timing T4 when the battery is fully charged. Further prior art can be found in DE11 2015 000880 T5 or WO 2014/167914 A1.

### [DISCLOSURE]

### [TECHNICAL PROBLEM]

In relation to a battery heating system, conventionally, as a preset heating function is activated simply under a condition that a temperature of a battery is a certain temperature or less, without considering specifications and a state of charge of a battery, specifications of a charger, etc., unnecessary power consumption occurs.

Embodiments disclosed herein aim to provide a battery heating apparatus and an operating method thereof in which power consumption caused by unnecessary battery heating may be reduced by determining whether to heat a battery based on various parameters (e.g., a state of charge and a temperature of the battery and a maximum charge power of a charger).

Technical problems of the embodiments disclosed herein are not limited to the above-described technical problems, and other unmentioned technical problems would be clearly understood by one of ordinary skill in the art from the following description.

### [TECHNICAL SOLUTION]

A battery heating apparatus according to an embodiment disclosed herein includes a state-of-charge calculating unit configured to calculate a state of charge (SoC) of a battery, a sensor unit configured to measure a voltage, a current, or a temperature of the battery, a controller configured to determine a charge power of the battery based on the state of charge of the battery and a maximum charge power of a charger to charge the battery, and determine whether to heat the battery based on the measured temperature and the charge power, and a heating unit configured to heat the battery when determining to heat the battery.

The battery heating apparatus according to an embodiment disclosed herein may further include a data obtaining unit configured to obtain information about the maximum charge power from an extern1al server, based on a user input for designating the charger.

In the battery heating apparatus according to the invention, the controller is further configured to estimate the maximum charge power based on a voltage and a current of the battery, measured for a designated time by the sensor unit, when the battery is being charged by the charger.

The battery heating apparatus according to an embodiment disclosed herein may further include a data obtaining unit configured to obtain charge history information of the battery from the external server, in which the controller may be further configured to estimate the maximum charge power further based on the charge history information.

In the battery heating apparatus according to an embodiment disclosed herein, the controller may be further configured to calculate an estimated charge amount of the battery based on the state of charge and a target state of charge and determine the charge power that is less than or equal to the maximum charge power, based on the estimated charge amount.

In the battery heating apparatus according to an embodiment disclosed herein, the controller may be further configured to calculate an estimated required charge time of the battery, based on the estimated charge amount and determine the charge power based on the estimated required charge time.

In the battery heating apparatus according to an embodiment disclosed herein, the controller may be further configured to determine whether the battery is chargeable with the charge power, based on the temperature and determine to heat the battery when determining that the battery is not chargeable with the charge power.

In the battery heating apparatus according to an embodiment disclosed herein, the controller may be further configured to calculate a reference temperature required for charging the battery with the charge power and determine that the battery is not chargeable with the charge power, when the temperature is less than the reference temperature.

A battery heating method according to an embodiment disclosed herein includes calculating a state of charge (SoC) of a battery, determining a charge power of the battery based on the state of charge of the battery and a maximum charge power of a charger to charge the battery, measuring a temperature of the battery, determining whether to heat the battery, based on the charge power and the measured temperature, and heating the battery when determining to heat the battery.

The battery heating method according to an embodiment disclosed herein may further include obtaining information about the maximum charge power from an external server, based on a user input for designating the charger.

The battery heating method according to the invention further includes estimating the maximum charge power based on a voltage and a current of the battery, measured for a designated time by the sensor unit, when the battery is being charged by the charger.

In the battery heating method according to an embodiment disclosed herein, the determining of the charge power may include calculating an estimated charge amount of the battery based on the state of charge and a target state of charge and determining the charge power that is less than or equal to the maximum charge power, based on the estimated charge amount.

In the battery heating method according to an embodiment disclosed herein, the determining of the charge power may include calculating an estimated required charge time of the battery, based on the estimated charge amount and determining the charge power based on the estimated required charge time.

In the battery heating method according to an embodiment disclosed herein, the determining of whether to heat the battery may include determining whether the battery is chargeable with the charge power, based on the measured temperature and determining to heat the battery when determining that the battery is not chargeable with the charge power.

In the battery heating method according to an embodiment disclosed herein, the determining of whether the battery is chargeable with the charge power may include calculating a reference temperature required for charging the battery with the charge power and determining that the battery is not chargeable with the charge power, when the measured temperature is less than the reference temperature.

### [ADVANTAGEOUS EFFECTS]

According to embodiments disclosed herein, the efficiency of power consumption may be improved by determining whether to heat a battery based on various parameters (e.g., a state of charge and a temperature of the battery and a maximum charge power of a charger).

According to embodiments disclosed herein, power consumption caused by unnecessary battery heating may be reduced.

Moreover, various effects recognized directly or indirectly from the disclosure may be provided.

### [DESCRIPTION OF DRAWINGS]

FIG. 1 is a block diagram of a battery heating system according to an embodiment.
FIG. 2 is an operating flowchart of a battery heating apparatus according to an embodiment.
FIG. 3 is an operating flowchart of a battery heating apparatus according to an embodiment.
FIG. 4 is an operating flowchart of a battery heating apparatus according to an embodiment.
FIG. 5 is an operating flowchart of a battery heating apparatus according to an embodiment.

### [MODE FOR INVENTION]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present document and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

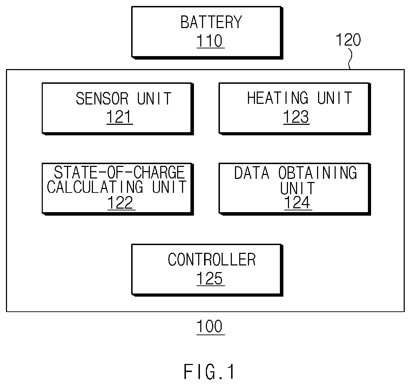

FIG. 1 is a block diagram of a battery heating system according to an embodiment.

Referring to FIG. 1, a battery heating system 100 may include a battery 110 and a battery heating apparatus 120.

The battery heating apparatus 120 may include a sensor unit 121, a state-of-charge calculating unit 122, a heating unit 123, a data obtaining unit 124, and/or a controller 125. According to some embodiments, in the battery heating apparatus 120, at least one of components of FIG. 1 may be omitted or one or more other components may be added.

The sensor unit 121 may be electrically connected to the battery 110. According to an embodiment, the sensor unit 121 may measure a voltage, a current, or a temperature of the battery 110. According to an embodiment, the sensor unit 121 may receive a measurement control signal from the controller 125 to measure the voltage, the current, or the temperature of the battery 110. The sensor unit 121 may measure the voltage, the current, or the temperature of the battery 110 each time when receiving the measurement control signal from the controller 125. According to an embodiment, the sensor unit 121 may transfer a measured voltage value, current value, or temperature value to the state-of-charge calculating unit 122 and/or the controller 125.

The state-of-charge calculating unit 122 may calculate a state of charge (SoC) of the battery 110. According to an embodiment, the state-of-charge calculating unit 122 may calculate a state of charge of the battery 110 based on at least one of the voltage value, the current value, or the temperature value of the battery 110, transferred from the sensor unit 121. According to an embodiment, the state-of-charge calculating unit 122 may transfer the calculated state of charge of the battery 110 to the controller 125.

The heating unit 123 may be a heating means arranged adjacent to the battery 110 to increase the temperature of the battery 110. According to an embodiment, the heating unit 123 may heat the battery 110 each time when receiving a heating control signal from the controller 125.

The data obtaining unit 124 may wiredly or wirelessly receive data from an external device and/or an external server. According to an embodiment, the data obtaining unit 124 may obtain the information about the maximum charge power of the charger to charge the battery 110 or charge history information of the battery 110 from an external server. According to an embodiment, the data obtaining unit 124 may transfer the obtained data to the controller 125.

The controller 125 may be electrically connected to the sensor unit 121, the state-of-charge calculating unit 122, the heating unit 123, and the data obtaining unit 124. According to an embodiment, the controller 125 may execute software to control at least one another component connected to the controller 125 and may process or compute various data. According to an embodiment, the controller 125 may control at least one another component connected to the controller 125 to perform an overall operation of the battery heating apparatus 120. The controller 125 may include at least one of processing devices such as an application specific integrated circuit (ASIC), a digital signal processor (DSP), programmable logic devices (PLD), field programmable gate arrays (FPGAs), a central processing unit (CPU), microcontrollers, or microprocessors.

According to an embodiment, the controller 125 may determine the charge power of the battery 110. Herein, the charge power may mean power to be supplied to the battery 110 from the charger to charge the battery 110. According to an embodiment, the controller 125 may determine the charge power of the battery 110 based on the maximum charge power of the charger to charge the battery 110 and the state of charge of the battery 110.

According to an embodiment, the controller 125 may identify whether there is a user input for designating the charger to charge the battery 110. According to an embodiment, the battery heating apparatus 120 may obtain the user input from an external device through the data obtaining unit 124. According to another embodiment, the battery heating apparatus 120 may include an interface unit for receiving the user input for designating the charger to charge the battery 110.

According to an embodiment, when identifying that there is the user input for designating the charger, the controller 125 may obtain information about the maximum charge power of the charger from the external server. According to an embodiment, the controller 125 may obtain information about the maximum charge power of the charger designated by a user from the external server through the data obtaining unit 124. For example, when identifying that there is a user input for designating a first electric vehicle charging station, the controller 125 may obtain information about a maximum charge power (e.g., 220 kW) of the first electric vehicle charging station from the external server through the data obtaining unit 124.

According to an embodiment, when identifying that there is no user input for designating the charger, the controller 125 may identify whether the battery 110 is charged. For example, the controller 125 may identify whether the battery 110 is charged according to whether the battery 110 is electrically connected to the external device. In another example, the controller 125 may identify whether the battery 110 is charged based on a voltage change or a current change of the battery 110.

According to an embodiment, the controller 125 may estimate the maximum charge power of the charger based on a voltage and a current of the battery measured for a designated time, when identifying that the battery 110 is being charged. According to an embodiment, the controller 125 may obtain the charge history information of the battery 110 from the external server through the data obtaining unit 124. In this case, the controller 125 may estimate the maximum charge power of the charger further based on the obtained charge history information.

According to an embodiment, the controller 125 may calculate an estimated charge amount of the battery 110 based on the state of charge and a target state of charge of the battery 110. Herein, the target state of charge may be set based on a charging pattern of a user using the external device including the battery 110, or may be a state of charge preset by the user. The estimated charge amount may mean a difference between the target state of charge and the current state of charge of the battery 110.

According to an embodiment, the controller 125 may calculate an estimated required charge time of the battery 110 based on the estimated charge amount.

According to an embodiment, the controller 125 may determine the charge power of the battery 110 based on the estimated charge amount or the estimated required charge time. According to an embodiment, the controller 125 may determine the charge power of the battery 110 according to the estimated charge amount or the estimated required charge time in a range below the maximum charge power of the charger. For example, the controller 125 may determine the charge power of the battery 110 to be higher for a higher estimated charge amount in the range below the maximum charge power of the charger. In another example, the controller 125 may determine the charge power of the battery 110 to be higher for a longer estimated required charge time in the range below the maximum charge power of the charger.

According to an embodiment, the controller 125 may measure a temperature of the battery 110 through the sensor unit 121.

According to an embodiment, the controller 125 may determine whether to heat the battery 110 based on the temperature of the battery 110. According to an embodiment, the controller 125 may determine whether the battery 110 is chargeable with the determined charge power.

According to an embodiment, the controller 125 may calculate a reference temperature based on the determined charge power of the battery 110. Herein, the reference temperature may be a temperature required for charging the battery 110 with the determined charge power. That is, the reference temperature may be a temperature at which a battery swelling phenomenon occurs when the battery 110 is charged with the determined charge power at a temperature lower than the reference temperature.

According to an embodiment, the controller 125 may identify whether the temperature of the battery 110 is less than the reference temperature.

According to an embodiment, the controller 125 may determine that the battery 110 is not chargeable with the charge power when identifying that the temperature of the battery 110 is less than the reference temperature. In this case, the controller 125 may heat the battery 110. According to an embodiment, the controller 125 may control the heating unit 123 to heat the battery 110.

According to an embodiment, the controller 125 may determine that the battery 110 is chargeable with the charge power when identifying that the temperature of the battery 110 is greater than or equal to the reference temperature. In this case, the controller 125 may not perform battery heating.

As such, the battery heating apparatus 120 may prevent the battery swelling phenomenon by determining whether to heat the battery 110 according to whether the temperature of the battery 110 is less than the reference temperature or greater than or equal to the reference temperature. The reference temperature may be calculated according to the charge power determined based on the state of charge of the battery 110 and the maximum charge power of the charger, thereby minimizing unnecessary battery heating. Thus, the battery heating apparatus 120 may reduce unnecessary power consumption.

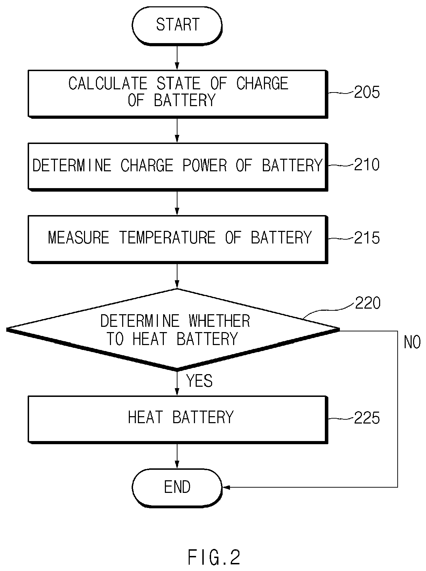

FIG. 2 is an operating flowchart of a battery heating apparatus according to an embodiment. FIG. 2 will be described using components of FIG. 1.

The embodiment shown in FIG. 2 may be an example, and an order of operations according to various embodiments of the present disclosure may be different from that shown in FIG. 2, and some operations shown in FIG. 2 may be omitted, the order of the operations may be changed, or the operations may be merged.

Referring to FIG. 2, in operation 205, the battery heating apparatus 120 may calculate the state of charge of the battery 110. According to an embodiment, the battery heating apparatus 120 may calculate the state of charge of the battery 110 based on at least one of the voltage value, the current value, or the temperature value of the battery 110.

In operation 210, the battery heating apparatus 120 may determine the charge power of the battery 110. Herein, the charge power may mean power to be supplied to the battery 110 from the charger to charge the battery 110. According to an embodiment, the battery heating apparatus 120 may determine the charging power of the battery 110 based on the maximum charging power of the charger to charge the battery 110 and the state of charge of the battery 110, calculated in operation 205. According to an embodiment, the battery heating apparatus 120 may determine the charge power of the battery 110 to be less than or equal to the maximum charge power of the charger. The battery heating apparatus 120 may also determine the charge power of the battery 110 according to the estimated charge amount calculated based on the state of charge of the battery 110. For example, the battery heating apparatus 120 may determine the charge power of the battery 110 to be higher for a higher estimated charge amount.

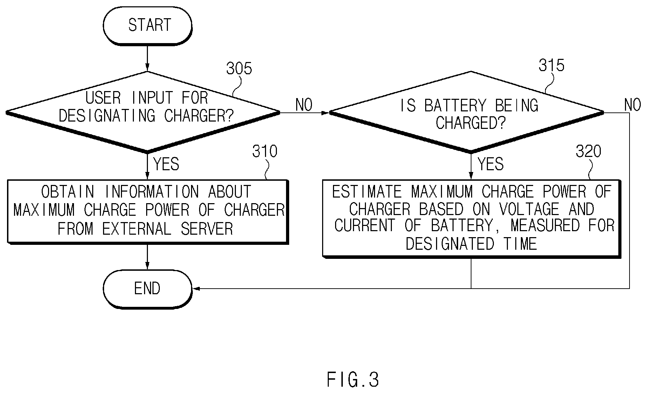

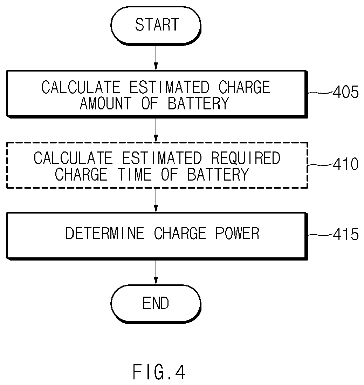

An operation, performed by the battery heating apparatus 120, of obtaining or estimating the maximum charge power of the charger will be described in detail with reference to FIG. 3. In addition, an operation, performed by the battery heating apparatus 120, of determining the charge power will be described in detail with reference to FIG. 4.

In operation 215, the battery heating apparatus 120 may measure the temperature of the battery 110.

In operation 220, the battery heating apparatus 120 may determine whether to heat the battery 110. According to an embodiment, the battery heating apparatus 120 may determine whether to heat the battery 110 based on the temperature of the battery 110, measured in operation 215.

According to an embodiment, the battery heating apparatus 120 may determine whether the battery 110 is chargeable with the charge power determined in operation 210. For example, the battery heating apparatus 120 may determine that the battery 110 is not chargeable with the charge power when the temperature of the battery 110 is less than the reference temperature. Herein, the reference temperature may be a temperature required for charging the battery 110 with the charge power determined in operation 210. That is, the reference temperature may be a temperature at which a battery swelling phenomenon occurs when the battery 110 is charged with the charge power determined in operation 210 at a temperature lower than the reference temperature.

As such, the battery heating apparatus 120 may prevent the battery swelling phenomenon by determining whether to heat the battery 110 according to whether the temperature of the battery 110 is less than the reference temperature or greater than or equal to the reference temperature. The reference temperature may be calculated according to the charge power determined based on the state of charge of the battery 110 and the maximum charge power of the charger, thereby minimizing unnecessary battery heating. Thus, the battery heating apparatus 120 may reduce unnecessary power consumption.

An operation, performed by the battery heating apparatus 120, of determining whether to perform battery heating will be described in detail with reference to FIG. 3.

When determining to heat the battery 110 ('YES') in operation 220, the battery heating apparatus 120 may heat the battery 110 in operation 225. According to an embodiment, the battery heating apparatus 120 may control the heating unit 123 to heat the battery 110.

FIG. 3 is an operating flowchart of a battery heating apparatus according to an embodiment. FIG. 3 will be described using components of FIG. 1.

The embodiment shown in FIG. 3 may be an example, and an order of operations according to various embodiments of the present disclosure may be different from that shown in FIG. 3, and some operations shown in FIG. 3 may be omitted, the order of the operations may be changed, or the operations may be merged.

FIG. 3 is a view for describing a method of obtaining or estimating the maximum charge power of the charger to charge the battery 110 among factors required for the battery heating apparatus 120 to determine the charge power in operation 210 of FIG. 2.

Referring to FIG. 3, in operation 305, the battery heating apparatus 120 may identify whether there is a user input for designating the charger to charge the battery 110. According to an embodiment, the battery heating apparatus 120 may obtain a user input made through the external device including the battery 110. According to another embodiment, the battery heating apparatus 120 may include an interface unit for receiving the user input for designating the charger to charge the battery 110. In this case, the battery heating apparatus 120 may perform operation 305 based on the user input received through the interface unit.

When identifying that there is a user input for designating the charger ('YES') in operation 305, the battery heating apparatus 120 may obtain the information about the maximum charge power of the charger from the external server in operation 310. According to an embodiment, the battery heating apparatus 120 may obtain the information about the maximum charge power of the charger designated in operation 305 from the external server through the data obtaining unit 124. For example, when identifying that there is a user input for designating a first electric vehicle charging station in operation 305, the battery heating apparatus 120 may obtain information about a maximum charge power (e.g., 220 kW) of the first electric vehicle charging station from the external server through the data obtaining unit 124.

When identifying that there is no user input for designating the charger ('NO') in operation 305, the battery heating apparatus 120 may identify whether the battery 110 is charged in operation 315. For example, the battery heating apparatus 120 may identify whether the battery 110 is charged according to whether the battery 110 is electrically connected to the external device. In another example, the battery heating apparatus 120 may identify whether the battery 110 is charged based on a voltage change or a current change of the battery 110.

When identifying that the battery 110 is not being charged ('NO') in operation 315, the battery heating apparatus 120 may terminate an operation corresponding to FIG. 3.

When identifying that the battery 110 is being charged ('YES') in operation 315, the battery heating apparatus 120 may estimate the maximum charge power of the charger based on the voltage and the current of the battery, measured for a designated time, in operation 320. According to an embodiment, the battery heating apparatus 120 may obtain the charge history information of the battery 110 from the external server. In this case, the battery heating apparatus 120 may estimate the maximum charge power of the charger further based on the obtained charge history information.

FIG. 4 is an operating flowchart of a battery heating apparatus according to an embodiment. FIG. 4 will be described using components of FIG. 1.

The embodiment shown in FIG. 4 may be an example, and an order of operations according to various embodiments of the present disclosure may be different from that shown in FIG. 4, and some operations shown in FIG. 4 may be omitted, the order of the operations may be changed, or the operations may be merged. For example, operation 410 may be omitted from FIG. 4.

FIG. 4 is a view for describing in detail a method, performed by the battery heating apparatus 120, of determining the charge power in operation 210 of FIG. 2.

Referring to FIG. 4, in operation 405, the battery heating apparatus 120 may calculate an estimated charge amount of the battery 110. According to an embodiment, the battery heating apparatus 120 may calculate the estimated charge amount of the battery 110 based on the state of charge, calculated in operation 205 of FIG. 2, and a target state of charge of the battery 110. Herein, the target state of charge may be set based on a charging pattern of a user using the external device including the battery 110, or may be a state of charge preset by the user. The estimated charge amount may mean a difference between the target state of charge and the state of charge calculated in operation 205.

In operation 410, the battery heating apparatus 120 may calculate an estimated required charge time of the battery 110. According to an embodiment, the battery heating apparatus 120 may calculate the estimated required charge time of the battery 110 based on the estimated charge amount calculated in operation 405.

In operation 415, the battery heating apparatus 120 may determine the charge power of the battery 110. Herein, the charge power may mean power to be supplied to the battery 110 from the charger to charge the battery 110. According to an embodiment, the battery heating apparatus 120 may determine the charge power of the battery 110 based on the estimated charge amount calculated in operation 405 or the estimated required charge time calculated in operation 410.

According to an embodiment, the battery heating apparatus 120 may determine the charge power of the battery 110 according to the estimated charge amount or the estimated required charge time in a range below the maximum charge power of the charger. For example, the battery heating apparatus 120 may determine the charge power of the battery 110 to be higher for a higher estimated charge amount in the range below the maximum charge power of the charger. In another example, the battery heating apparatus 120 may determine the charge power of the battery 110 to be higher for a longer estimated required charge time in the range below the maximum charge power of the charger.

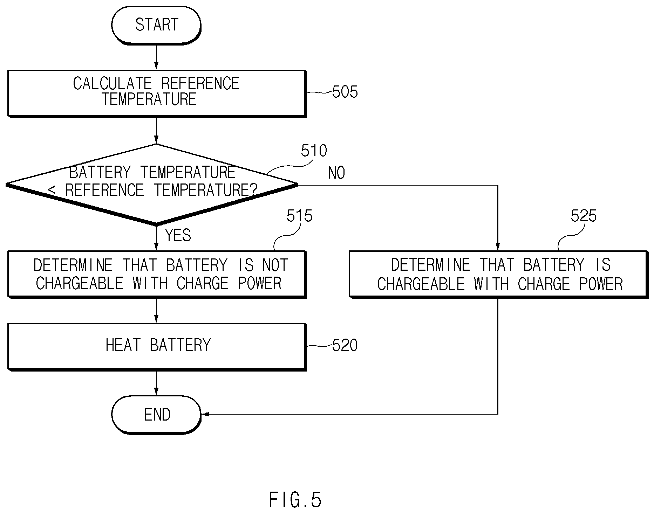

FIG. 5 is an operating flowchart of a battery heating apparatus according to an embodiment. FIG. 5 will be described using components of FIG. 1.

The embodiment shown in FIG. 5 may be an example, and an order of operations according to various embodiments of the present disclosure may be different from that shown in FIG. 5, and some operations shown in FIG. 5 may be omitted, the order of the operations may be changed, or the operations may be merged.

FIG. 5 is a view for describing in detail operations 220 and 225 of FIG. 2 where the battery heating apparatus 120 determines whether to perform battery heating and performs battery heating.

Referring to FIG. 5, in operation 505, the battery heating apparatus 120 may calculate a reference temperature. According to an embodiment, the battery heating apparatus 120 may calculate the reference temperature based on the charge power determined in operation 210 of FIG. 2. Herein, the reference temperature may be a temperature required for charging the battery 110 with the charge power determined in operation 210 of FIG. 2. That is, the reference temperature may be a temperature at which a battery swelling phenomenon occurs when the battery 110 is charged with the charge power determined in operation 210 at a temperature lower than the reference temperature.

In operation 510, the battery heating apparatus 120 may identify whether the temperature of the battery 110 measured in operation 215 of FIG. 2 is less than the reference temperature calculated in operation 505.

When identifying that the temperature of the battery 110 is less than the reference temperature ('YES') in operation 510, the battery heating apparatus 120 may determine that the battery 110 is not chargeable with the charge power in operation 515.

In operation 520, the battery heating apparatus 120 may heat the battery 110. According to an embodiment, the battery heating apparatus 120 may control the heating unit 123 to heat the battery 110.

When identifying that the temperature of the battery 110 is greater than or equal to the reference temperature ('NO') in operation 510, the battery heating apparatus 120 may determine that the battery 110 is chargeable with the charge power in operation 525. In this case, the battery heating apparatus 120 may not perform battery heating.

As such, the battery heating apparatus 120 may prevent the battery swelling phenomenon by determining whether to heat the battery 110 according to whether the temperature of the battery 110 is less than the reference temperature or greater than or equal to the reference temperature. The reference temperature may be calculated according to the charge power determined based on the state of charge of the battery 110 and the maximum charge power of the charger, thereby minimizing unnecessary battery heating. Thus, the battery heating apparatus 120 may reduce unnecessary power consumption.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

## Claims

1. A battery heating apparatus (120) comprising:
a state-of-charge calculating unit (122) configured to
calculate a state of charge (SoC) of a battery (110);
a sensor unit (121) configured to
measure a voltage, a current, and a temperature of the battery (110);
a controller (125) configured to
determine a charge power of the battery (110) based on the state of charge of the battery (110) and a maximum charge power of a charger to charge the battery (110), and
determine whether to heat the battery (110) based on the measured temperature and the charge power; and
a heating unit (123) configured to
heat the battery (110) when determining to heat the battery (110)
**characterized in that** the controller (125) is further configured to
estimate the maximum charge power based on a voltage and a current of the battery (110), measured for a designated time by the sensor unit (121), when the battery (110) is being charged by the charger.

2. The battery heating apparatus (120) of claim 1, further comprising
a data obtaining unit (124) configured to
obtain information about the maximum charge power from an external server, based on a user input for designating the charger.

3. The battery heating apparatus (120) of claim 1, further comprising
a data obtaining unit (124) configured to
obtain charge history information of the battery (110) from an external server,
wherein the controller (125) is further configured to
estimate the maximum charge power further based on the charge history information.

4. The battery heating apparatus (120) of claim 1,
wherein the controller (125) is further configured to:
calculate an estimated charge amount of the battery (110) based on the state of charge and a target state of charge; and
determine the charge power that is less than or equal to the maximum charge power, based on the estimated charge amount.

5. The battery heating apparatus (120) of claim 4,
wherein the controller (125) is further configured to:
calculate an estimated required charge time of the battery (110), based on the estimated charge amount; and
determine the charge power based on the estimated required charge time.

6. The battery heating apparatus (120) of claim 1,
wherein the controller (125) is further configured to:
determine whether the battery (110) is chargeable with the charge power, based on the temperature; and
determine to heat the battery (110) when determining that the battery (110) is not chargeable with the charge power.

7. The battery heating apparatus (120) of claim 6,
wherein the controller (125) is further configured to:
calculate a reference temperature required for charging the battery (110) with the charge power; and
determine that the battery (110) is not chargeable with the charge power, when the temperature is less than the reference temperature.

8. A battery heating method comprising:
calculating (205) a state of charge (SoC) of a battery (110);
determining (210) a charge power of the battery (110) based on the state of charge of the battery (110) and a maximum charge power of a charger to charge the battery (110);
measuring (215) a temperature of the battery (110);
determining (220) whether to heat the battery (110), based on the charge power and the measured temperature; and
heating (225) the battery (110) when determining to heat the battery (110);
**characterized by**
estimating (320) the maximum charge power based on a voltage and a current of the battery (110), measured for a designated time by the sensor unit (121), when the battery (110) is being charged by the charger.

9. The battery heating method of claim 8, further comprising
obtaining (310) information about the maximum charge power from an external server, based on a user input for designating the charger.

10. The battery heating method of claim 8, wherein the determining (210) of the charge power comprises:
calculating (405) an estimated charge amount of the battery (110) based on the state of charge and a target state of charge; and
determining (415) the charge power that is less than or equal to the maximum charge power, based on the estimated charge amount.

11. The battery heating method of claim 10, wherein the determining (210) of the charge power comprises:
calculating (410) an estimated required charge time of the battery (110), based on the estimated charge amount; and
determining (415) the charge power based on the estimated required charge time.

12. The battery heating method of claim 8, wherein the determining (220) of whether to heat the battery (110) comprises:
determining (510) whether the battery (110) is chargeable with the charge power, based on the measured temperature; and
determining (520) to heat the battery (110) when determining (515) that the battery (110) is not chargeable with the charge power.

13. The battery heating method of claim 12, wherein the determining (220) of whether the battery (110) is chargeable with the charge power comprises:
calculating (505) a reference temperature required for charging the battery (110) with the charge power; and
determining (515) that the battery (110) is not chargeable with the charge power, when the measured temperature is less than the reference temperature.

## Patentansprüche

1. Batterieheizvorrichtung (120) aufweisend:
eine Ladezustandsberechnungseinheit (122), die konfiguriert ist zum
Berechnen eines Ladezustands (SoC) einer Batterie (110);
eine Sensoreinheit (121), die konfiguriert ist zum
Messen einer Spannung, eines Stroms und einer Temperatur der Batterie (110);
eine Steuerung (125), die konfiguriert ist zum
Bestimmen einer Ladeleistung der Batterie (110) basierend auf dem Ladezustand der Batterie (110) und einer maximalen Ladeleistung eines Ladegeräts zum Laden der Batterie (110), und
Bestimmen, ob die Batterie (110) erwärmt werden soll, basierend auf der gemessenen Temperatur und der Ladeleistung; und
eine Heizeinheit (123), die konfiguriert ist zum
Erwärmen der Batterie (110), wenn bestimmt wird, die Batterie (110) zu erwärmen
**dadurch gekennzeichnet, dass** die Steuerung (125) ferner konfiguriert ist zum
Schätzen der maximalen Ladeleistung basierend auf einer Spannung und einem Strom der Batterie (110), die für eine bestimmte Zeit durch die Sensoreinheit (121) gemessen werden, wenn die Batterie (110) durch das Ladegerät geladen wird.

2. Batterieheizvorrichtung (120) nach Anspruch 1, ferner aufweisend
eine Datenerhaltungseinheit (124), die konfiguriert ist zum
Erhalten von Informationen über die maximale Ladeleistung von einem externen Server, basierend auf einer Benutzereingabe zum Bestimmen des Ladegeräts.

3. Batterieheizvorrichtung (120) nach Anspruch 1, ferner aufweisend
eine Datenerhaltungseinheit (124), die konfiguriert ist zum
Erhalten von Ladeverlaufsinformationen der Batterie (110) von einem externen Server,
wobei die Steuerung (125) ferner konfiguriert ist zum
Schätzen der maximalen Ladeleistung ferner basierend auf den Ladeverlaufsinformationen.

4. Batterieheizvorrichtung (120) nach Anspruch 1,
wobei die Steuerung (125) ferner konfiguriert ist zum:
Berechnen einer geschätzten Lademenge der Batterie (110) basierend auf dem Ladezustand und einem Zielladezustand; und
Bestimmen der Ladeleistung, die kleiner oder gleich der maximalen Ladeleistung ist, basierend auf der geschätzten Lademenge.

5. Batterieheizvorrichtung (120) nach Anspruch 4,
wobei die Steuerung (125) ferner konfiguriert ist zum:
Berechnen einer geschätzten erforderlichen Ladezeit der Batterie (110) basierend auf der geschätzten Lademenge; und
Bestimmen der Ladeleistung basierend auf der geschätzten erforderlichen Ladezeit.

6. Batterieheizvorrichtung (120) nach Anspruch 1,
wobei die Steuerung (125) ferner konfiguriert ist zum:
Bestimmen, ob die Batterie (110) mit der Ladeleistung aufladbar ist, basierend auf der Temperatur; und
Bestimmen, die Batterie (110) zu erwärmen, wenn bestimmt wird, dass die Batterie (110) nicht mit der Ladeleistung aufladbar ist.

7. Batterieheizvorrichtung (120) nach Anspruch 6,
wobei die Steuerung (125) ferner konfiguriert ist zum:
Berechnen einer Referenztemperatur, die zum Laden der Batterie (110) mit der Ladeleistung erforderlich ist; und
Bestimmen, dass die Batterie (110) nicht mit der Ladeleistung aufladbar ist, wenn die Temperatur niedriger als die Referenztemperatur ist.

8. Batterieheizverfahren aufweisend:
Berechnen (205) eines Ladezustands (SoC) einer Batterie (110);
Bestimmen (210) einer Ladeleistung der Batterie (110) basierend auf dem Ladezustand der Batterie (110) und einer maximalen Ladeleistung eines Ladegeräts zum Laden der Batterie (110);
Messen (215) einer Temperatur der Batterie (110);
Bestimmen (220), ob die Batterie (110) erwärmt werden soll, basierend auf der Ladeleistung und der gemessenen Temperatur; und
Erwärmen (225) der Batterie (110), wenn bestimmt wird, die Batterie (110) zu erwärmen;
**gekennzeichnet durch**
Schätzen (320) der maximalen Ladeleistung basierend auf einer Spannung und einem Strom der Batterie (110), die für eine bestimmte Zeit durch die Sensoreinheit (121) gemessen werden, wenn die Batterie (110) durch das Ladegerät geladen wird.

9. Batterieheizverfahren nach Anspruch 8, ferner umfassend:
Erhalten (310) von Informationen über die maximale Ladeleistung von einem externen Server, basierend auf einer Benutzereingabe zum Bestimmen des Ladegeräts.

10. Batterieheizverfahren nach Anspruch 8, wobei das Bestimmen (210) der Ladeleistung umfasst:
Berechnen (405) einer geschätzten Lademenge der Batterie (110) basierend auf dem Ladezustand und einem Zielladezustand; und
Bestimmen (415) der Ladeleistung, die kleiner oder gleich der maximalen Ladeleistung ist, basierend auf der geschätzten Lademenge.

11. Batterieheizverfahren nach Anspruch 10, wobei das Bestimmen (210) der Ladeleistung umfasst:
Berechnen (410) einer geschätzten erforderlichen Ladezeit der Batterie (110) basierend auf der geschätzten Lademenge; und
Bestimmen (415) der Ladeleistung basierend auf der geschätzten erforderlichen Ladezeit.

12. Batterieheizverfahren nach Anspruch 8, wobei das Bestimmen (220), ob die Batterie (110) erwärmt werden soll, umfasst:
Bestimmen (510), ob die Batterie (110) mit der Ladeleistung aufladbar ist, basierend auf der gemessenen Temperatur; und
Bestimmen (520), die Batterie (110) zu erwärmen, wenn bestimmt wird (515), dass die Batterie (110) nicht mit der Ladeleistung aufladbar ist.

13. Batterieheizverfahren nach Anspruch 12, wobei das Bestimmen (220), ob die Batterie (110) mit der Ladeleistung aufladbar ist, umfasst:
Berechnen (505) einer Referenztemperatur, die zum Laden der Batterie (110) mit der Ladeleistung erforderlich ist; und
Bestimmen (515), dass die Batterie (110) nicht mit der Ladeleistung aufladbar ist, wenn die gemessene Temperatur niedriger als die Referenztemperatur ist.

## Revendications

1. Appareil de chauffage de batterie (120) comprenant :
un module de calcul de l'état de charge (122) configuré pour
calculer l'état de charge (SoC) d'une batterie (110);
un capteur (121) configuré pour
mesurer une tension, un courant, et une température de la batterie (110) ;
un régulateur (125) configuré pour
déterminer une puissance de charge de la batterie (110) d'après l'état de charge de la batterie (110), et une puissance de charge maximale d'un chargeur pour charger la batterie (110), et
déterminer la nécessité de chauffer la batterie (110) en fonction de la température mesurée et de la puissance de charge ; et
un dispositif de chauffage (123) configuré pour
chauffer la batterie (110) lors de la détermination du chauffage de la batterie (110)
**caractérisé en ce que** le régulateur (125) est configuré en outre pour
estimer la puissance de charge maximale basée sur une tension et un courant de la batterie (110), mesurés pendant une période désignée par le capteur (121), lors de la charge de la batterie (110) par le chargeur.

2. Appareil de chauffage de batterie (120) selon la revendication 1, comprenant en outre une unité d'obtention de données (124) configurée pour
obtenir d'un serveur externe des informations sur la puissance de charge maximale, d'après une entrée utilisateur pour désigner le chargeur.

3. Appareil de chauffage de batterie (120) selon la revendication 1, comprenant en outre une unité d'obtention de données (124) configurée pour
obtenir d'un serveur externe des informations sur l'historique de charge de la batterie (110), le régulateur (125) étant configuré en outre pour
estimer la puissance de charge maximale, sur la base en outre des informations sur l'historique de charge.

4. Appareil de chauffage de batterie (120) selon la revendication 1,
le régulateur (125) étant configuré en outre pour :
calculer une quantité de charge estimée de la batterie (110) d'après la l'état de charge et un état de charge cible ; et
déterminer la puissance de charge qui soit inférieure ou égale à la puissance de charge maximale, d'après la quantité de charge estimée.

5. Appareil de chauffage de batterie (120) selon la revendication 4,
le régulateur (125) étant configuré en outre pour :
calculer un temps de charge requis estimé pour la batterie (110), d'après la quantité de charge estimée ; et
déterminer la puissance de charge basée sur le temps de charge requis estimé.

6. Appareil de chauffage de batterie (120) selon la revendication 1,
le régulateur (125) étant configuré en outre pour :
déterminer, d'après la température, si la batterie (110) peut être chargée avec la puissance de charge ; et
décider de chauffer la batterie (110) lors de la détermination que la batterie (110) ne peut être chargée avec la puissance de charge.

7. Appareil de chauffage de batterie (120) selon la revendication 6,
le régulateur (125) étant configuré en outre pour :
calculer une température de référence requise pour charger la batterie (110) avec la puissance de charge ; et
déterminer que la batterie (110) ne peut être chargée avec la puissance de charge lorsque la température est inférieure à la température de référence.

8. Procédé de chauffage d'une batterie comprenant :
le calcul (205) d'un état de charge (SoC) d'une batterie (110);
la détermination (210) d'une puissance de charge de la batterie (110) d'après l'état de charge de la batterie (110), et d'une puissance de charge maximale d'un chargeur pour charger la batterie (110) ;
la mesure (215) d'une température de la batterie (110) ;
la détermination (220) de la nécessité de chauffer la batterie (110) en fonction de la puissance de charge et de la température mesurée ; et
le chauffage (225) de la batterie (110) lors de la détermination du chauffage de la batterie (110) ;
**caractérisé par**
l'estimation (320) de la puissance de charge maximale basée sur une tension et un courant de la batterie (110), mesurés pendant une période désignée par le capteur (121), lors de la charge de la batterie (110) par le chargeur.

9. Procédé de chauffage d'une batterie selon la revendication 8, comprenant en outre :
l'obtention (310), d'un serveur externe, d'informations sur la puissance de charge maximale, d'après une entrée utilisateur pour désigner le chargeur.

10. Procédé de chauffage d'une batterie selon la revendication 8, la détermination (210) de la puissance de charge comprenant :
le calcul (405) d'une quantité de charge estimée de la batterie (110) d'après l'état de charge et un état de charge cible ; et
la détermination (415) de la puissance de charge qui soit inférieure ou égale à la puissance de charge maximale, d'après la quantité de charge estimée.

11. Procédé de chauffage d'une batterie selon la revendication 10, la détermination (210) de la puissance de charge comprenant :
le calcul (410) d'un temps de charge requis estimé pour la batterie (110), d'après la quantité de charge estimée ; et
la détermination (415) de la puissance de charge basée sur le temps de charge requis estimé.

12. Procédé de chauffage d'une batterie selon la revendication 8, la détermination (220) de la nécessité de chauffer la batterie (110) comprenant :
la détermination (510), d'après la température mesurée, si la batterie (110) peut être chargée avec la puissance de charge ; et
la détermination (520) du chauffage de la batterie (110) après avoir établi (515) que la batterie (110) ne peut être chargée avec la puissance de charge.

13. Procédé de chauffage d'une batterie selon la revendication 12, la détermination (220) de la possibilité de chauffer la batterie (110) avec la puissance de charge comprenant :
le calcul (505) d'une température de référence requise pour charger la batterie (110) avec la puissance de charge ; et
la détermination (515) que la batterie (110) ne peut être chargée avec la puissance de charge lorsque la température mesurée est inférieure à la température de référence.
